# EUROPEAN PATENT APPLICATION

(11) **EP 2 869 226 A1**
(43) Date of publication of application: **06.05.2015**
(21) Application number: 14191943.1
(22) Date of filing: 05.11.2014
(51) Int. Cl.: G06F 17/50

(54) **Updating a CAD model to reflect global or local shape changes**

(30) Priority: 05.11.2013 US 201314072189
(71) Applicant: Spatial Corporation, Broomfield, CO 80021 (US)
(72) Inventor: Seibold, Wolfgang, LaFayette, CO Colorado 80026 (US); Tomas, Brian, Louisville, CO Colorado 80027 (US)
(74) Representative: Style, Kelda Camilla Karen

(57) **Abstract**

The present invention relates to a method and system for updating a CAD model. The method and system generate a parameterization of each respective face of at least one FEA model, each respective face of the at least one FEA model corresponds to a respective geometric face of a CAD model to be updated and each face of the at least one FEA model has a respective shape. Next, a respective shape function for at least one face of the at least one FEA model is determined using the respective shape of the at least one face and the corresponding generated parameterization. The determined shape function describes the shape of the at least one face. The CAD model is then updated using the determined shape function.

## Description

### BACKGROUND OF THE INVENTION

The invention generally relates to the field of computer programs and systems, and specifically to the field of computer aided design (CAD), computer-aided engineering (CAE), modeling, and simulation.

A number of systems and programs are offered on the market for the design of parts or assemblies of parts, such as those provided by Dassault Systemes. These so called CAD systems allow a user to construct and manipulate complex three-dimensional models of objects or assemblies of objects. CAD systems thus provide a representation of modeled objects using edges or lines, in certain cases with faces. Lines or edges may be represented in various manners, e.g., nonuniform rational basis-splines (NURBS).

These CAD systems manage parts or assemblies of parts of modeled objects, which are mainly specifications of geometry. In particular, CAD files contain specifications, from which geometry is generated. From geometry, a representation is generated. Specifications, geometry, and representations may be stored in a single CAD file or multiple CAD files. CAD systems include graphic tools for representing the modeled objects to the designers; these tools are dedicated to the display of complex objects - the typical size of the file representing an object in a CAD system ranges, but is typically on the megabyte order of magnitude for a part. An assembly may contain thousands of parts, and an assembly file is correspondingly large. A CAD system manages models of objects, which are stored in electronic files.

### SUMMARY OF THE INVENTION

A method and corresponding system according to an embodiment of the present invention are directed to updating a computer aided design (CAD) model. An embodiment of the present invention begins by generating a parameterization of each respective face of at least one finite element analysis (FEA) model. According to such an embodiment each respective face of the at least one FEA model corresponds to a respective geometric face of a CAD model to be updated and each face of the at least one FEA model has a respective shape. In such an embodiment, the next step is to determine a shape function for at least one face of the at least one FEA model using the respective shape of the at least one face and the corresponding generated parameterization of the at least one face. The determined shape function describes the shape of the at least one face of the at least one FEA model. Finally, the CAD model is updated using the determined shape function.

According to an embodiment of the present invention the at least one FEA model used for updating the CAD model comprises a FEA model and a modified version of the FEA model. In an embodiment of the present invention wherein the at least one FEA model comprises a FEA model and a modified version of the FEA model, such an embodiment may further comprise generating the modified version of the FEA model using the FEA model and at least one physics-based analysis. According to such an embodiment, the physics-based analysis may be one of a stress analysis type, a fluid analysis type, a heat dissipation analysis type, and/or an electromagnetic analysis type.

An alternative embodiment of the present invention may further comprise generating the at least one FEA model from the CAD model before generating the parameterization of each respective face of the at least one FEA model. In yet another embodiment of the present invention, the method begins by generating both a FEA model based upon the CAD model to be updated and a modified version of said FEA model using a physics-based analysis.

According to an embodiment of the present invention generating the parameterization for each respective face of the at least one FEA model begins by determining one or more respective sets of surface polygons that correspond to the respective faces of the at least one FEA model. In such an embodiment the surface polygons are associated with FEA model elements, the model elements comprising nodes and edges. Next, respective UV parameter values for points in respective CAD surfaces which define the CAD model are determined. The points in the respective CAD surfaces correspond to the nodes associated with the surface polygons that correspond to the respective faces of the at least one FEA model. Finally, the interior of each surface polygon is uv-parameterized such that the uv-parameter values determined for the points in the respective CAD surfaces agree with the uv-parameterization of the interior of each surface polygon and such that adjacent polygons have agreeing uv- parameterization of a common edge.

According to such an embodiment of the present invention, uv-parameterizing the interior of each surface polygon is done using a surface fitting algorithm. In yet another embodiment, the surface fitting algorithm is an energy-minimization B-spline surface fitting algorithm.

According to yet another embodiment of the present invention, the respective shape of each face of the at least one FEA model is based on nodes of the at least one FEA model. In another embodiment of the present invention the determined shape function of the at least one face of the at least one FEA model is a G1 shape function. Yet further still, according to another embodiment of the method of the present invention, the generated parameterization of each respective face of the at least one FEA model maps points in the respective faces of the at least one FEA model to corresponding points on each respective surface of the geometric faces of the CAD model.

An alternative embodiment of the present invention is directed to a system for updating a CAD model. In such an embodiment, the system comprises a parameterization module configured to generate a parameterization of each respective face of at least one FEA model wherein each respective face of the at least one FEA model corresponds to a respective geometric face of a CAD model to be updated. Further, an embodiment of the system further comprises a shape function module which is configured to determine a respective shape function for at least one face of the at least one FEA model using the respective shape of the at least one face and the corresponding generated parameterization of the at least one face. According to the principles of the present invention, the determined shape function describes the shape of the at least one face of the at least one FEA model. Yet further still, the system comprises an update module which is configured to update the CAD model using the determined shape function output by the shape function module.

According to an embodiment of the system of the present invention the FEA model comprises a FEA model and a modified version of the FEA model. In an alternative embodiment of the system, the system further comprises an optimization module configured to generate a modified version of the FEA model using the FEA model and at least one physics-based analysis which is one of a stress analysis type, a fluid analysis type, a heat dissipation analysis type, and/or an electromagnetic analysis type. According to another embodiment, the system further comprises a FEA model generation module which is configured to generate the at least one FEA model from the CAD model which is to be updated.

According to an alternative embodiment of the system, the parameterization module may be configured to generate the parameterization for each respective face of the at least one FEA model using a process which comprises determining one or more respective sets of surface polygons that correspond to the respective faces of the at least one FEA model, wherein the surface polygons are associated with FEA model elements, the model elements being nodes and edges. The process (of the parameterization module) further comprises determining respective uv-parameter values for points in respective CAD surfaces which define the CAD model, the points in the respective CAD surfaces corresponding to the nodes associated with the surface polygons that correspond to the respective faces of the at least one FEA model. According to such an embodiment of the system, the process for generating the parameterization for each respective face of the at least one FEA model further comprises uv-parameterizing the interior of each surface polygon such that (i) the uv-parameter values determined for the points in the respective CAD surfaces agree with the uv-parameterization of the interior of each surface polygon, and such that (*ii*) adjacent polygons have agreeing uv-parameterization of a common edge.

According to an embodiment of the system, the parameterization module may be configured to determine the uv-parameterization of the interior of each surface polygon using a surface fitting algorithm. In yet another embodiment of the present invention, the respective shape of the least one FEA model is based on nodes of the at least one FEA model. Yet further still, in an alternative embodiment of the present invention the determined shape function for the at least one face of the at least one FEA model is a G1 shape function. In yet another embodiment of the present invention, the parameterization module generates a parameterization of each respective face of the at least one FEA model that maps points in the respective faces of the at least one FEA model to corresponding points on each respective surface of the geometric faces of the CAD model.

Another embodiment of the present invention is directed to a computer implemented method wherein a non-transitory computer readable medium having stored thereon a sequence of instructions which, when loaded and executed by a processor coupled to an apparatus, causes the apparatus to: generate a parameterization of each respective face of the at least one FEA model, each respective face of the at least one FEA model corresponding to a respective geometric face of the CAD model to be updated and each face of the at least one FEA model having a respective shape, determine a respective shape function for at least one face of the at least one FEA model using the respective shape of the at least one face and the corresponding generated parameterization of the at least one face, the determined shape function describing the shape of the at least one face of the at least one FEA model, and finally update the CAD model using the determined shape function.

### BRIEF DESCRIPTION OF THE DRAWINGS

The foregoing will be apparent from the following more particular description of example embodiments of the invention, as illustrated in the accompanying drawings in which like reference characters refer to the same parts throughout the different views. The drawings are not necessarily to scale, emphasis instead being placed upon illustrating embodiments of the present invention.
FIG. 1 is a flowchart depicting a method of updating a computer-aided design (CAD) model according to principles of the present invention.
FIG. 2 is a flowchart of a method of generating a parameterization of each respective face of at least one finite element analysis (FEA) model that may be implemented in an embodiment of the present invention.
FIG. 3 is a flow diagram depicting the processing flow of updating a CAD model according to an embodiment of the invention.
FIG. 4 depicts a workflow for updating a CAD model using an embodiment of the present invention.
FIG. 5 is simplified block diagram illustrating a system according to the principles of the present invention.
FIG. 6 is a simplified diagram of a computer system in which an embodiment of the present invention may be embodied.

### DETAILED DESCRIPTION OF THE INVENTION

A description of example embodiments of the invention follows.

The advent of computer aided design (CAD) and computer aided engineering (CAE) systems allows for a wide range of representation possibilities for objects. One such representation is finite element analysis (FEA) model. The terms FEA model, finite element mesh, and mesh are used interchangeably throughout this application. A finite element mesh is a system of points called nodes which are interconnected to make a grid, referred to as a mesh. The mesh may be programmed in such a way that the mesh has the properties of the underlying object that it represents. When a mesh is programmed in such a way, it may be used to perform simulations of the object that it represents. For example, a finite element mesh may be used to represent the interior cavity of a vehicle, the acoustic fluid surrounding a structure, and any number of real-world objects, including medical devices such as stents. When a given mesh represents an object and is programmed accordingly it may be used to simulate the real-world object itself. For example, a mesh representing a stent may be used to simulate the use of the stent in a real-life medical setting.

Finite element meshes are regularly used for optimization studies. Once an optimized finite element mesh is determined it can then be given as feedback to a CAD designer so that the underlying CAD model can be generated. The underlying CAD model provides a geometrical representation of the optimized finite element mesh. This underlying CAD model, i.e., updated CAD model, can in turn be used for iterative design processes. For example, further simulations can be performed using a mesh generated from the updated CAD model. Further still, once a designer is satisfied with the updated CAD model, the updated CAD model can be used in generating manufactured products (by rendering blue-print quality views, parts lists, indications of dimensions per part, etc.).

The process of generating the CAD model based upon the optimized mesh however can be a lengthy process. Thus, a method that can efficiently generate (including render or display through a computer, a user-interactive display of) a CAD model from a finite element mesh is needed. While solutions exist for generating a CAD model from a finite element mesh the existing solutions are inadequate. One type of existing solution attempts to adjust the shape of an initial CAD model to match the shape of the FEA model. One example of this solution attempts a global deformation of the space imbedding the CAD model. This global deformation is calculated so as to move the original nodes of the FEA mesh to their final position. Consequently, the final FEA model stays unchanged, and the result is a changed CAD model. Another example attempts to deform individual faces of the CAD model according to the FEA result. Yet another example attempts to reproduce a CAD model of the FEA result by hand, using the FEA result as a guide. Other examples of this solution exist, all of which presumably attempt to adjust the parameters of the shape functions of the CAD model, e.g. the radius of cylinders, so that the surface shape of the CAD model is close to that of the FEA model.

Another type of existing solution does not actually directly apply FEA shape-changes to a model. Instead parameters which define the shape of the model are varied in an optimization loop, where each new shape obtained by varying the parameters is evaluated using FEA. This type of solution is less relevant to embodiments of the present invention, because it applies to a workflow that performs multiple FEA calculations to evaluate shape changes in the CAD model. One example of this solution uses global deformation techniques to perform such shape changes to the model. Another example of the solution is described in the paper "A CAD-Based Design Parameterization for Shape Optimization of Solids" in Advances in Engineering Software 30, Issue 3, March '99 by Hardee, *et al.* This paper describes a method for using FEA simulations to do a search over the design parameters of the CAD model, e.g. the radius of a sphere to form an optimal shape. Embodiments of the present invention support the workflow of performing a single FEA calculation then applying the resulting shape change to the CAD model.

While there is a solution that attempts to adjust the shape of an initial CAD model to match the shape of the FEA model, as described herein above, the existing solutions in the art do not utilize surface types in the CAD model whose degrees of freedom correspond to the locations of the FEA model nodes. However, in embodiments of the present invention the final CAD model exactly interpolates the nodes of the final FEA model. In this way, embodiments of the present invention employ the degrees of freedom as the dimensions of the vector space in which the interpolating function is defined.

In addition, the existing solutions of the art that attempt to adjust the shape of the initial CAD model to match the shape of the FEA model have surface types, such as B-Splines which have non-corresponding degrees of freedom. Therefore, the existing methods all have to perform some sort of optimization step over the degrees of freedom of the surfaces which minimize the shape deviation between the surface of the FEA model and the surface of the CAD model. Because the degrees of freedom being varied do not correspond to the degrees of freedom of the FEA model, the optimization problem is not assured of finding a good answer; in addition it can be computationally expensive.

The other type of existing solution in the art requires multiple FEA calculations and while this type of solution is only relevant to a different workflow, it is discussed here because that workflow might be considered to be in competition to the workflow which embodiments of the present invention support. The primary drawback of this existing solution is performing multiple FEA calculations while searching for an optimal shape; said FEA calculations are typically extremely expensive in computer time. In contrast, the embodiments of the present invention obtain a shape change from a single FEA calculation.

Embodiments of the present invention solve the technical problem by introducing a new type of CAD surface function which has degrees of freedom which exactly correspond to the degrees of freedom of a corresponding region of the FEA mesh's surface. Ultimately, these degrees of freedom can be adjusted to match the corresponding FEA model degrees of freedom, resulting in an exact shape match that can be calculated without resorting to a nontrivial optimization algorithm.

Embodiments of the present invention have several advantages over existing solutions. For example, embodiments of the present invention, exactly, up to smoothing for non-G1 FEA meshes, replicate the shape of the surface of the FEA model, require fewer computations and therefore will run much faster, and can be completely automated requiring no human intervention to match shapes.

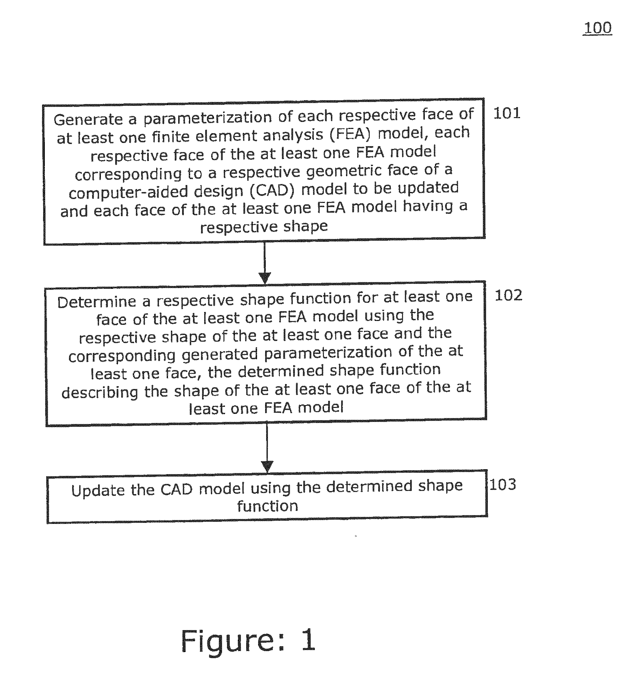

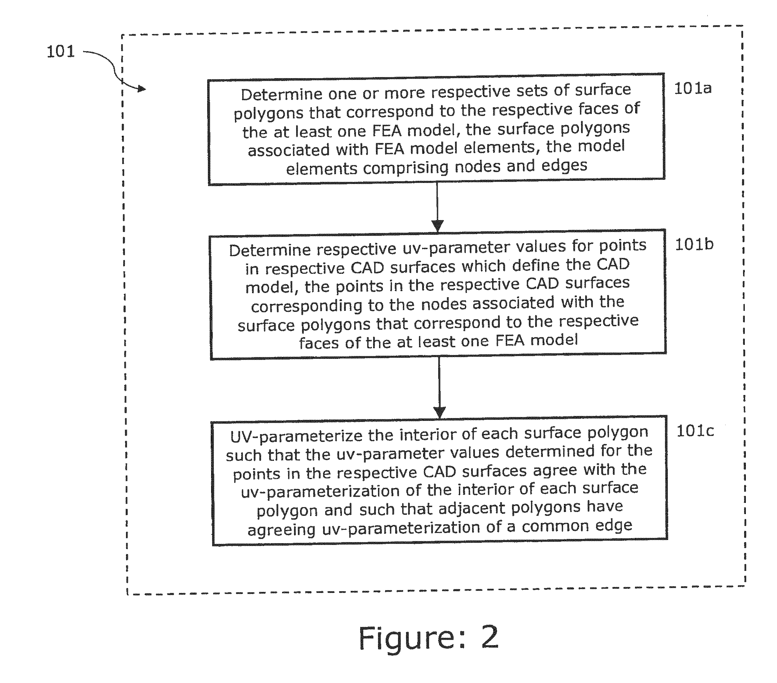

FIG. 1 is a flowchart of a method 100 of updating a CAD model from a finite element mesh according to the principles of the present invention. The method 100 begins by generating a parameterization of each respective face of at least one FEA model (101). In such an embodiment, each respective face of the at least one FEA model corresponds to a respective geometric face of the CAD model which is to be updated, and each face of the at least one FEA model has a respective shape. The parameterization of each respective face may be determined according to any principles as are known in the art. Further, in an example embodiment of the present invention, the parameterization of each respective face of the FEA model may be determined according to the method 101 as shown in FIG. 2. According to an embodiment of the present invention the at least one FEA model may comprise a FEA model and a modified version of the FEA model. In such an embodiment, it may be said that the FEA model comprises both an original mesh that corresponds to the CAD model to be updated, and an optimized mesh which corresponds to the resulting updated CAD model. In such an embodiment both the original mesh and the optimized mesh are used in the method 100 of updating the CAD model. Thus, a parameterization of each face of both the original and optimized mesh is generated in step 101 of the method 100, and a respective shape function is determined for each face of the original and optimized mesh in step 102, described below.

In step 101, a parameterization is generated for each face of the CAD model by first finding the corresponding region on the surface of the FEA model which will be referred to herein as a FEA face. In an embodiment this FEA face consists of a set of surface polygons associated with FEA elements, i.e. nodes and edges. Then for each node of the FEA faces, the corresponding uv-parameter value in the CAD surface is determined. Next, the interior of each polygon in the FEA face is uv-parameterized using an interpolating parameterization scheme, such as Clough-Tocher parameterization, such that the uv-parameterization of the FEA nodes agrees with the uv-parameter values determined for each node of the FEA face and such that two adjacent FEA polygons have agreeing parameterization of the FEA edge between them. Alternatively, a surface fitting algorithm, such as an energy minimization B-spline surface fitting algorithm, may be used to uv-parameterize the interior of each surface polygon. This process may result in a map between every point in the FEA face and a corresponding point on the faces of the CAD surfaces. In particular, it may assign a uv-value to every point on the FEA face. This may be referred to as the parameterization of the FEA face. According to an embodiment of the present invention, the aforementioned process of generating a parameterization for each face of the CAD model may be done using the original FEA model as described herein. In yet another embodiment the parameterization is determined for both the original FEA model and the modified FEA model.

The next step 102 of the method 100 is to determine a respective shape function for at least one face of the at least one FEA model using the respective shape of the at least one face and the corresponding generated parameterization of the at least one face. The shape function determined in step 102 of the method 100 describes the shape of the at least one face of the at least one FEA model. Step 102 may be accomplished according to any method as is known in the art. Further, in an embodiment of the invention wherein the FEA model comprises an original mesh and an optimized mesh, the difference between the original mesh and optimized mesh defines a vector field in each mesh node, which is an xyz point. At each node point, the shape function is the vector sum of the original shape plus this vector field. The vector field at the nodes may be fit as a vector field over the entire mesh, and this produces a shape function over the entire face of the CAD model. To summarize, the difference between the modified mesh and the original mesh gives one the desired vector field at the node points. Thus, given the original mesh and the modified mesh, one knows how specifically the CAD model is to change shape at the node points. Also, the nodes of the original mesh have known corresponding points on the original CAD model, so one can map that shape change to precise locations on the CAD model to be updated. The aforementioned described fitting process may be used in step 102, of the method 100 (or a corresponding module 102), for determining a respective shape function of the at least one face of the FEA model using the respective shape of the at least one face and the corresponding generated parameterization of the at least one face.

An embodiment of the invention uses the shape of the FEA mesh face as determined by the FEA nodes and the parameterization of the FEA mesh face to generate a G1 shape function from uv to xyz which describes the shape of the FEA mesh face, wherein "uv" refers to the two dimensional (2D) parameter domain of an FEA mesh face and "xyz" refers to the global 3D coordinate system of the FEA model. This method may be used in step 102 of the method 100. According to such an embodiment of the invention, if the FEA mesh is defined by quadratic or higher shape functions for its elements, then the subject shape function can be directly obtained from the FEA mesh nodes and the FEA mesh-shape function as long as the resulting shape function is G1 across element boundaries. If the FEA mesh uses linear shape functions i.e. flat elements, then an intermediate step needs to be performed which promotes the FEA mesh to a G1 surface. One way to achieve this is by using cubic elements constrained to be G1 across the elements boundary, wherein elements may be the nodes and edges of a FEA model. If the CAD model requires shape functions which support a parametric uv-space rectangle, then the subject shape function can be extended to a uv-rectangle by introducing additional nodes and polygons outside the boundary of the FEA face and assigning them XYZ locations according to some smoothness condition on the resulting shape.

In an exemplary embodiment, the final step of the method 100 is to update (103) the CAD model using the determined shape function from or output by step 102. The CAD model may be updated using the determined shaped function according to principles as are known in the art.

Embodiments of the method 100 may further comprise generating the modified version of the FEA model using the FEA model and at least one physics-based analysis. According to such an embodiment the physics-based analysis may be any physics-based analysis as is known in the art. For example a stress analysis type, a fluid analysis type, a heat dissipation analysis type, and/or an electromagnetic analysis type may be used. Further embodiments of the present invention may use any combination of physics-based analysis types to determine an optimized mesh. Yet further still, alternative embodiments of the present invention may optimize the FEA model using any optimization technique or combination of optimization techniques as are known in the art.

Further embodiments of the present invention may begin with only a CAD model to be updated. In such an embodiment a mesh is first determined using the CAD model according principles as are known in the art. Further, this determined mesh may then be processed to determine an optimized mesh. In such an embodiment there is a modified mesh, an optimized mesh, and a CAD model to be updated to correspond to the modified mesh. These three representations/elements can then be used in an embodiment of the present invention, such as the method 100, to update the CAD model to correspond to the optimized mesh.

FIG. 2 illustrates the method step 101 of the method 100 as described in FIG 1 of generating a parameterization of each respective face of the FEA model. The parameterization method or module 101 begins by determining (101a) one or more respective sets of surface polygons that correspond to the respective faces of the at least one FEA model. In such an embodiment, the surface polygons are associated with FEA model elements which are nodes and edges. Next, respective UV parameter values for points in the respective CAD surfaces which define the CAD model to be updated are determined (101b). The points in the respective CAD surfaces correspond to the nodes associated with the surface polygons that correspond to the respective faces of the at least one FEA model. Finally, the method 101 concludes by computing a parameterization for the interior of each surface polygon (101c) such that the uv-parameter values determined for the points in the respective CAD surfaces agree with the uv-parameterization of the interior of each surface polygon and such that adjacent polygons have agreeing uv-parameterization of a common edge (101c). In an embodiment of the present invention the parameterization is a one-to-one mapping of a sub-domain of R² to R³ wherein R² and R³ refer to the Euclidean space in two and three dimensions respectively, as known in the art.

According to an embodiment of the present invention uv-parameterizing the interior of each surface polygon (101c) is done using a surface fitting algorithm. In such an embodiment the surface fitting algorithm may be an energy minimization B-Spline surface fitting algorithm. In yet another embodiment of the method 100, the respective shape of each face of the at least one FEA model is based on nodes of the at least one FEA model.

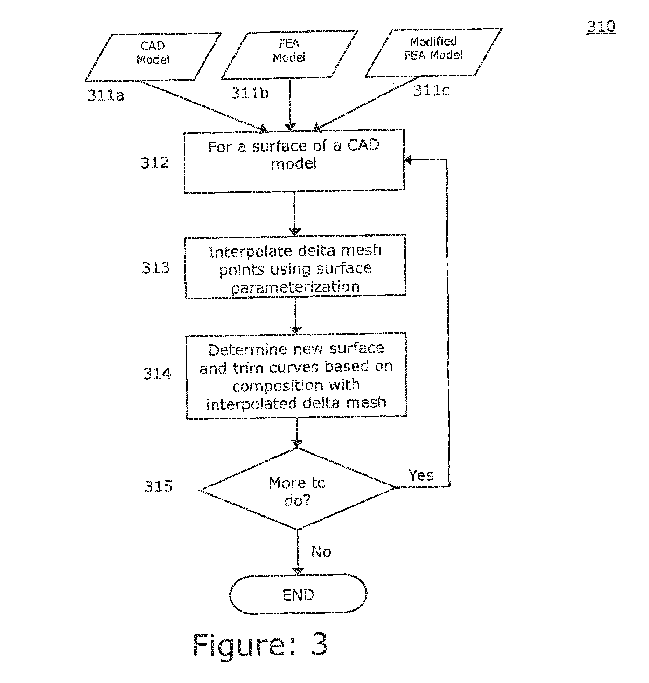

FIG. 3 illustrates a method 310 of (or module for) updating a CAD model according to an embodiment of the present invention. The method/module 310 begins with inputting a CAD model (311a), an FEA model (311b), and a modified FEA model (311 c). Next, for each surface of the CAD model, a series or loop of processing steps 312-315 is performed beginning at 312. For a given surface of the CAD model, delta mesh points are interpolated using surface parameterization (313). In an embodiment of the invention, the delta mesh points are determined using the FEA model and the modified FEA model, wherein the delta mesh points are the differences between the FEA model and the modified FEA model. Then, new surface and trim curves are determined based upon composition with the interpolated delta mesh (314). In an embodiment of the invention, the interpolated delta mesh defines a mapping from the 3D points on the original CAD model into a sub-domain of R³. The new surfaces and trim curves may be based on composing the original surfaces and trim curves of the CAD model with this mapping. One consequence of such is that the new surfaces and trim curves interpolate the modified mesh points. Decision juncture 315 determines if there are more CAD model surfaces to process using steps 312-314. If so, the loop restarts at 312 after decision 315 but with another surface of the CAD model. If there are no more CAD model surfaces to process, then method 310 ends.

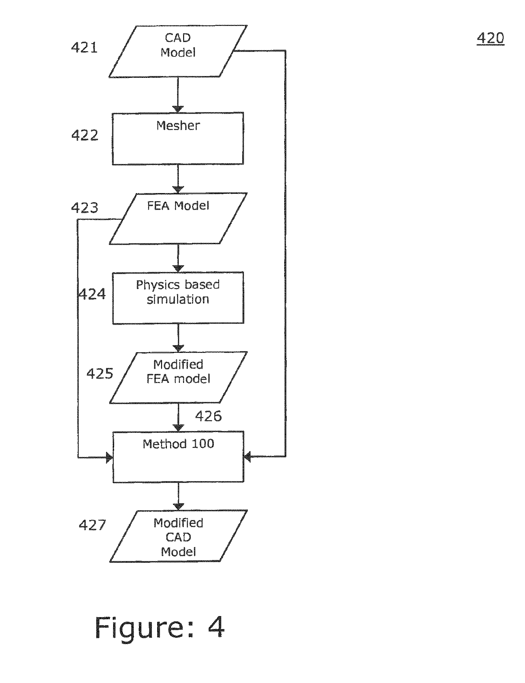

FIG. 4 is a simplified flow diagram illustrating a workflow in which an embodiment of the present invention may be implemented. The workflow 420 begins with input of the CAD model (421). Next, the CAD model is processed by a mesher (422) and a FEA model is generated (423). One version of the FEA model is passed to step 426 which may embody the method 100 for updating the CAD model 421. Another version of the FEA model is input to a physics-based simulation (424) which outputs a modified FEA model (425). This modified FEA model is input to step 426 along with the original FEA model of 423. Step 426 may embody the CAD model update method 100 or any embodiment of the present invention described herein. Finally, using the FEA model (of 423), modified FEA model (of 425), and original CAD model 421, step 426 updates the original CAD model to correspond with the modified FEA model. The results of the CAD model updating of step 426 is output as a modified/updated CAD model 427.

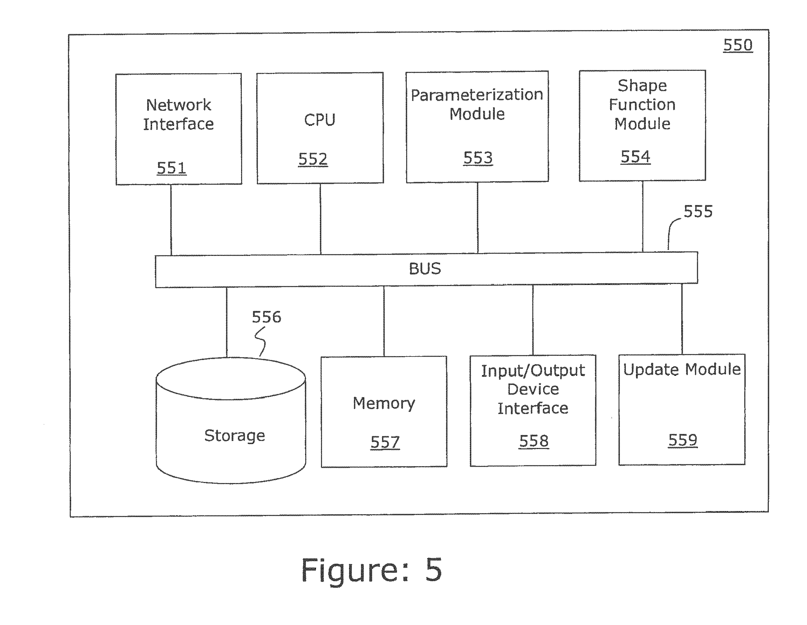

FIG. 5 is a simplified block diagram of a computer-based system 550 which may be used to update a CAD model according to the principles of the present invention. The system 550 comprises a bus 555. The bus 555 serves as an interconnect between the various components of the system 550. Connected to the bus 555 is input-output device interface 558 for connecting various input and output devices such as a keyboard, mouse, display, speakers, etc. to the system 550. Central processing unit (CPU) 552 is connected to the bus 555 and provides for the execution of computer instructions. Memory 557 provides volatile storage for data used for carrying out computer instructions. Storage 556 provides non-volatile storage for software instructions such as an operating system (not shown). The system 550 also comprises a network interface 551 for connecting to any variety of networks, including wide-area networks (WANs) and local area networks (LANs).

Further connected to the bus 555 is a parameterization module 553. The parameterization module 553 may be configured to generate a parameterization of each respective face of at least one FEA model. Each respective face of the at least one FEA model corresponds to a respective geometric face of the CAD model which is to be updated. Communicatively coupled to the parameterization module 553 is a shape function module 554. The shape function module 554 is configured to determine a respective shape for at least one face of the at least one FEA model using the respective shape of the at least one face and the corresponding generated parameterization of the at least one face. The determined shape function describes the shape of the at least one face of the at least one FEA model. Further connected to the bus 555 is an update module 559. The update module 559 is responsive to the result of the shape function module 554. The update module 559 is configured to update the CAD model using the shape function determined by the shape function module 554.

The system 550 and its various modules may be configured to carry out any of the embodiments of the present invention as described herein. As described herein, embodiments of the present invention may begin with any combination of a CAD model, FEA model and/or modified FEA model. Thus, the system 550 may through any of its various components, such as the network interface 551 and/or input/out device interface 558 receive a FEA model, corresponding modified FEA model, and/or corresponding CAD model. Similarly, the system 550 may output through I/O devices of interface 558 the result of any of the various processes that the system 550 carries out. Further, according to an embodiment of the system 550 the modules as described herein may be software modules that may be executed by a processor, such as the CPU 552. An alternative embodiment of the system 550 further comprises an optimization module. The optimization module may be configured to generate the modified version of the FEA model using an FEA model and at least one physics-based analysis. The system 550 may further comprise an FEA model generation module which is configured to generate the at least one FEA model from the CAD model which is to be updated.

According to an embodiment of the system 550 the parameterization module 553 may be configured to generate the parameterization of each respective face of the at least one FEA model using a process that comprises determining one or more respective sets of surface polygons that correspond to the respective faces of the at least one FEA model, wherein the surface polygons are associated with the FEA model elements, the FEA model elements comprising nodes and edges. The aforementioned process for generating the parameterization of each respective face of the at least one FEA model further comprises determining respective uv-parameter values for points in respective CAD surfaces which define the CAD model. The points in the respective CAD surfaces correspond to the nodes associated with the surface polygons that correspond to respective faces of the at least one FEA model. Finally, the process concludes with uv-parameterizing the interior of each surface polygon such that the uv-parameter values determined for the points in the respective CAD surfaces agree with the uv-parameterization of the interior of each surface polygon and such that adjacent polygons have an agreeing uv-parameterization of a common edge.

According to an alternative embodiment of the system 550, the uv-parameterization module 553 may be further configured to determine the uv-parameterization of the interior of each surface polygon using a surface fitting algorithm. In an alternative embodiment of the system 550, the respective shape of each face of the at least one FEA model may be based on nodes of the at least one FEA model. In another embodiment of the system 550 and shape function module 554, the determined shape function for the at least one face of the at least one FEA model is a G1 shape function. In an alternative embodiment of the system 550 the generated parameterization of each respective face of the at least one FEA model maps points in the respective faces of the at least one FEA model to corresponding points on each respective surface of the geometric faces of the CAD model.

A further embodiment of the present invention is directed to a computer implemented method. In such an embodiment a non-transitory computer readable medium having stored thereon a sequence of instructions which, when loaded and executed by a processor coupled to an apparatus causes the apparatus to update a CAD model based upon a modified mesh. In such an embodiment, the processor/apparatus begins by generating a parameterization of each respective face of at least one FEA model, each respective face of the at least one FEA model corresponding to a respective geometric face of CAD model to be updated. Next, a respective shape function is determined for at least one face of the at least one FEA model using the respective shape of the at least one face and the corresponding generated parameterization of the at least one face, the determined shape function describing the shape of the at least one face of the at least one FEA model. Finally, the processor/apparatus concludes by updating the CAD model using the determined shape function.

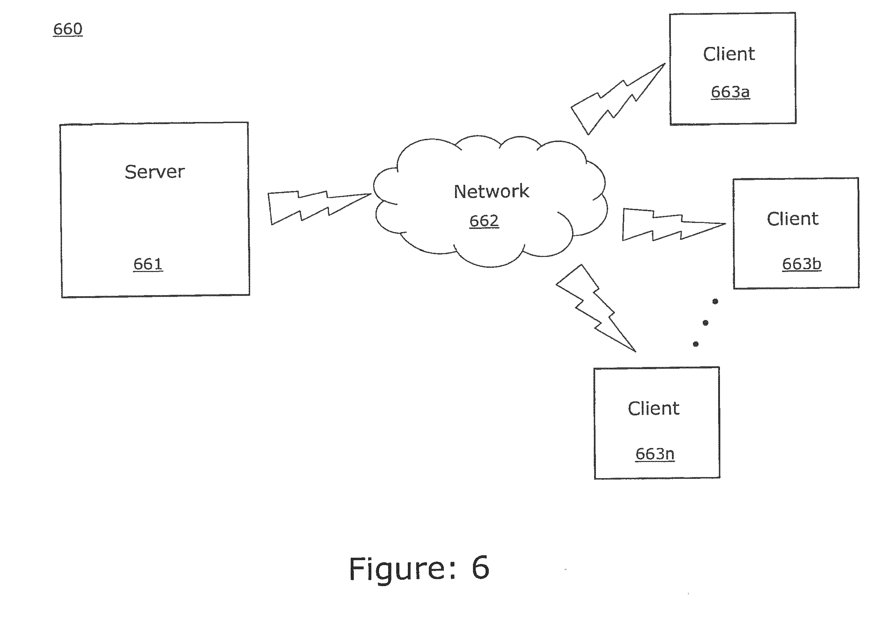

FIG. 6 illustrates a computer network environment 660 in which an embodiment of the present invention may be implemented. In the computer network environment 660, server 661 is linked through a communication network 662 to clients 663a-n. The environment 660 may be used to allow the clients 663a-n, alone or in combination with the server 661, to execute the methods described hereinabove. It should be understood that the example embodiments described above may be implemented in many different ways. In some instances, the various methods and machines described herein may each be implemented by a physical, virtual, or hybrid general purpose computer, or computer network environment such as the computer environment 660.

Embodiments or aspects thereof may be implemented in the form of hardware, firmware, or software. If implemented in software the software may be stored on any non-transient computer readable medium that is configured to enable a processor to load the software or subsets of instructions thereof. The processor then executes the instructions and is configured to operate or cause an apparatus to operate in a manner as described herein.

Further, firmware, software, routines, or instructions may be described herein as performing certain actions and/or functions of the data processors. However, it should be appreciated that such descriptions contained herein are merely for convenience and that such actions in fact result from computing devices, processors, controllers, or other devices executing the firmware, software, routines, instructions, etc.

It also should be understood that the flow diagrams, block diagrams, and network diagrams may include more or fewer elements, be arranged differently, or be represented differently. But it further should be understood that certain implementations may dictate the block and network diagrams and the number of block and network diagrams illustrating the execution of the embodiments be implemented in a particular way.

Accordingly, further embodiments may also be implemented in a variety of computer architectures, physical, virtual, cloud computers, and/or some combination thereof, and, thus, the data processors described herein are intended for purposes of illustration only and not as a limitation of the embodiments.

The teachings of all patents, published applications and references cited herein are incorporated by reference in their entirety.

While this invention has been particularly shown and described with references to example embodiments thereof, it will be understood by those skilled in the art that various changes in form and details may be made therein without departing from the scope of the invention encompassed by the appended claims.

## Claims

1. A method for updating a computer-aided design (CAD) model, the method comprising:
generating a parameterization of each respective face of at least one finite element analysis (FEA) model, each respective face of the at least one FEA model corresponding to a respective geometric face of a computer-aided design (CAD) model to be updated and each face of the at least one FEA model having a respective shape;
determining a respective shape function for at least one face of the at least one FEA model using the respective shape of the at least one face and the corresponding generated parameterization of the at least one face, the determined shape function describing the shape of the at least one face of the at least one FEA model; and
updating the CAD model using the determined shape function.

2. The method of claim 1 wherein the at least one FEA model comprises:
a FEA model; and
a modified version of the FEA model.

3. The method of claim 2 further comprising:
generating the modified version of the FEA model using the FEA model and at least one physics-based analysis which is one of a stress analysis type, a fluid analysis type, a heat dissipation analysis type and/or an electromagnetic analysis type.

4. The method of claim 1 further comprising:
generating the at least one FEA model from the CAD model before generating the parameterization of each respective face of the at least one FEA model.

5. The method of claim 1 wherein generating the parameterization for each respective face of the at least one FEA model comprises:
determining one or more respective sets of surface polygons that correspond to the respective faces of the at least one FEA model, the surface polygons associated with FEA model elements, the model elements comprising nodes and edges;
determining respective uv-parameter values for points in respective CAD surfaces which define the CAD model, the points in the respective CAD surfaces corresponding to the nodes associated with the surface polygons that correspond to the respective faces of the at least one FEA model; and
uv-parameterizing the interior of each surface polygon such that the uv-parameter values determined for the points in the respective CAD surfaces agree with the uv-parameterization of the interior of each surface polygon and such that adjacent polygons have agreeing uv-parameterization of a common edge.

6. The method of claim 5 wherein uv-parameterizing the interior of each surface polygon is done using a surface fitting algorithm.

7. The method of claim 6 wherein the surface fitting algorithm is an energy-minimization B-spline surface fitting algorithm.

8. A system for updating a computer-aided design (CAD) model, the system comprising:
a parameterization module configured to generate a parameterization of each respective face of at least one finite element analysis (FEA) model, each respective face of the at least one FEA model corresponding to a respective geometric face of a computer-aided design (CAD) model to be updated and each face of the at least one FEA model having a respective shape;
a shape function module configured to determine a respective shape function for at least one face of the at least one FEA model using the respective shape of the at least one face and the corresponding generated parameterization of the at least one face, the determined shape function describing the shape of the at least one face of the at least one FEA model; and
an update module configured to update the CAD model using the determined shape function.

9. The system of claim 8 further comprising:
an optimization module configured to generate a modified version of the FEA model using a FEA model and at least one physics-based analysis which is one of a stress analysis type, a fluid analysis type, a heat dissipation analysis type and/or an electromagnetic analysis type.

10. The system of claim 8 further comprising:
a FEA model generation module configured to generate the at least one FEA model from the CAD model.

11. The system of claim 8 wherein the parameterization module is configured to generate the parameterization for each respective face of the at least one FEA model using a process comprising:
determining one or more respective sets of surface polygons that correspond to the respective faces of the at least one FEA model, the surface polygons associated with FEA model elements, the model elements comprising nodes and edges;
determining respective uv-parameter values for points in respective CAD surfaces which define the CAD model, the points in the respective CAD surfaces corresponding to the nodes associated with the surface polygons that correspond to the respective faces of the at least one FEA model; and
uv-parameterizing the interior of each surface polygon such that the uv-parameter values determined for the points in the respective CAD surfaces agree with the uv-parameterization of the interior of each surface polygon and such that adjacent polygons have agreeing uv-parameterization of a common edge.

12. The system of claim 11 wherein the parameterization module is configured to determine the uv-parameterization of the interior of each surface polygon using a surface fitting algorithm.

13. The method or system of any preceding claim wherein the respective shape of each face of the at least one FEA model is based on nodes of the at least one FEA model.

14. The method or system of any preceding claim wherein the determined shape function for the at least one face of the at least one FEA model is a G1 shape function.

15. The method or system of any preceding claim wherein the generated parameterization of each respective face of the at least one FEA model maps points in the respective faces of the at least one FEA model to corresponding points on each respective surface of the geometric faces of the CAD model.

16. A non-transitory computer readable medium having stored thereon a sequence of instructions which, when loaded and executed by a processor coupled to an apparatus, causes the apparatus to:
generate a parameterization of each respective face of at least one finite element analysis (FEA) model, each respective face of the at least one FEA model corresponding to a respective geometric face of a computer-aided design (CAD) model to be updated and each face of the at least one FEA model having a respective shape;
determine a respective shape function for at least one face of the at least one FEA model using the respective shape of the at least one face and the corresponding generated parameterization of the at least one face, the determined shape function describing the shape of the at least one face of the at least one FEA model; and
update the CAD model using the determined shape function.
